# EUROPEAN PATENT APPLICATION

(11) **EP 4 428 898 A2**
(43) Date of publication of application: **11.09.2024**
(21) Application number: 24175547.9
(22) Date of filing: 20.04.2021
(51) Int. Cl.: H01J 37/32

(54) **SUBSTRATE PROCESSING METHOD AND PLASMA PROCESSING APPARATUS**

(30) Priority: 30.04.2020 US 202063017998 P; 09.11.2020 US 202017092376; 19.03.2021 JP 2021046015
(62) Divisional of application: 21169517.6
(71) Applicant: Tokyo Electron Limited, Tokyo 107-6325 (JP)
(72) Inventor: SUDA, Ryutaro, Miyagi 981-3629 (JP); TOMURA, Maju, Miyagi 981-3629 (JP)
(74) Representative: Jacob, Reuben Ellis

(57) **Abstract**

A technique improves selectivity in etching of a silicon-containing film over etching of a mask in plasma etching. A substrate processing method includes providing a substrate in a chamber in a plasma processing apparatus. The substrate includes a silicon-containing film and a mask on the silicon-containing film. The substrate processing method further includes controlling a temperature of a substrate support on which the substrate is placed to 0 °C or lower. The substrate processing method further includes etching the silicon-containing film with plasma generated from a first process gas containing a hydrogen fluoride gas and at least one carbon-containing gas selected from the group consisting of a fluorocarbon gas and a hydrofluorocarbon gas. The etching includes etching the film with a chemical species contained in the plasma. The hydrogen fluoride gas has a highest flow rate among non-inert components of the first process gas.

## Description

### FIELD

Exemplary embodiments of the present disclosure relate to a substrate processing method and a plasma processing apparatus.

### BACKGROUND

A method for etching a film included in a substrate is described in Japanese Unexamined Patent Application Publication No. 2016-39310. The film contains silicon. The substrate further includes a mask on the film. The mask contains amorphous carbon or an organic polymer. The etching uses plasma generated from a process gas containing a hydrocarbon gas and a hydrofluorocarbon gas.

### SUMMARY

The present disclosure is directed to a technique for improving selectivity in etching of a silicon-containing film over etching of a mask in plasma etching.

A substrate processing method according to an aspect of the present disclosure includes providing a substrate in a chamber. The substrate includes a silicon-containing film and a mask on the silicon-containing film. The substrate processing method further includes controlling a temperature of a substrate support on which the substrate is placed to 0 °C or lower. The substrate processing method further includes etching the silicon-containing film with plasma generated from a first process gas containing a hydrogen fluoride gas and at least one carbon-containing gas selected from the group consisting of a fluorocarbon gas and a hydrofluorocarbon gas. The etching includes etching the silicon-containing film with a chemical species contained in the plasma. The hydrogen fluoride gas has a highest flow rate among non-inert components of the first process gas.

The exemplary technique according to the present disclosure improves selectivity in etching of the silicon-containing film over etching of the mask in plasma etching.

### BRIEF DESCRIPTION OF THE DRAWINGS

FIG. 1 is a flowchart of an exemplary substrate processing method according to a first embodiment.
FIG. 2 is a schematic diagram of an exemplary plasma processing apparatus according to an embodiment.
FIG. 3 is a partially enlarged cross-sectional view of an exemplary substrate placed in step ST11.
FIG. 4 is a partially enlarged cross-sectional view of the exemplary substrate after being processed with the substrate processing method shown in FIG. 1.
FIG. 5 is a timing chart of an exemplary substrate processing method.
FIG. 6 is a graph showing the results of a first experiment conducted for evaluating the substrate processing method shown in FIG. 1.
FIG. 7 is a graph showing the results of a second experiment conducted for evaluating the substrate processing method shown in FIG. 1.
FIG. 8A is a graph showing the results of a third experiment, and FIG. 8B is a graph showing the results of a fourth experiment.
FIG. 9 is a flowchart of an exemplary substrate processing method according to a second embodiment.
FIG. 10 is a flowchart of an exemplary substrate processing method according to a third embodiment.
FIG. 11 is a flowchart of an exemplary substrate processing method according to a modification of the third embodiment.

### DETAILED DESCRIPTION

Exemplary embodiments will now be described.

A substrate processing method according to one exemplary embodiment includes providing a substrate in a chamber in a plasma processing apparatus. The substrate includes a silicon-containing film including a silicon oxide film and a mask on the silicon-containing film. The substrate processing method further includes controlling a temperature of a substrate support on which the substrate is placed to 0 °C or lower. The substrate processing method further includes etching the silicon-containing film with plasma generated from a first process gas containing a hydrogen fluoride gas and at least one carbon-containing gas selected from the group consisting of a fluorocarbon gas and a hydrofluorocarbon gas. The etching includes etching the silicon-containing film with a chemical species contained in the plasma. The hydrogen fluoride gas has a highest flow rate among non-inert components of the first process gas. The method according to the embodiment improves selectivity in etching of the silicon-containing film over etching of the mask with the plasma generated from the first process gas containing the hydrogen fluoride gas having the highest flow rate among the non-inert components of the first process gas.

In one exemplary embodiment, the hydrogen fluoride gas may have a flow rate of at least 70 vol% of a total flow rate of the non-inert components of the first process gas.

In one exemplary embodiment, the fluorocarbon gas may include at least one selected from the group consisting of CF₄, C₂F₂, C₂F₄, C₃F₈, C₄F₆, C₄F₈, and C₃F₈.

In one exemplary embodiment, the fluorocarbon gas may include a C₄F₈ gas.

In one exemplary embodiment, the hydrofluorocarbon gas may include at least one selected from the group consisting of CHF₃, CH₂F₂, CH₃F, C₂HF₅, C₂H₂F₄, C₂H₃F₃, C₂H₄F₂, C₃HF₇, C₃H₂F₂, C₃H₂F₆, C₃H₂F₄, C₃H₃F₅, C₄H₅F₅, C₄H₂F₆, C₅H₂F₁₀, and c-C₅H₃F₇.

In one exemplary embodiment, the hydrofluorocarbon gas may include at least one selected from the group consisting of a C₃H₂F₄ gas and a C₄H₂F₆ gas.

In one exemplary embodiment, the first process gas may further contain at least one selected from the group consisting of an oxygen-containing gas and a halogen-containing gas.

In one exemplary embodiment, the first process gas may further contain at least one selected from the group consisting of a phosphorus-containing gas, a sulfur-containing gas, and a boron-containing gas.

In one exemplary embodiment, the hydrogen fluoride gas may have a flow rate of not more than 96 vol% of a total flow rate of the non-inert components of the first process gas.

In one exemplary embodiment, the silicon-containing film may include at least one selected from the group consisting of a silicon oxide film, a film stack including a silicon oxide film and a silicon nitride film, and a film stack including a silicon oxide film and a polysilicon film.

In one exemplary embodiment, the mask may include a carbon-containing mask or a metal-containing mask.

In one exemplary embodiment, the carbon-containing mask may include at least one selected from the group consisting of spin-on carbon, tungsten carbide, amorphous carbon, and boron carbide.

In one exemplary embodiment, the substrate processing method may further include generating plasma from a second process gas in the chamber. The generating plasma from the second process gas includes cleaning an inside of the chamber with a chemical species contained in the plasma.

In one exemplary embodiment, the second process gas may contain at least one selected from the group consisting of a fluorine-containing gas, an oxygen-containing gas, a hydrogen-containing gas, and a nitrogen-containing gas.

In one exemplary embodiment, the substrate processing method may further include generating plasma from a third process gas in the chamber before the providing the substrate. The generating plasma from the third process gas includes depositing a precoat on an inner wall of the chamber.

In one exemplary embodiment, the third process gas may contain a carbon-containing gas.

A substrate processing method according to another exemplary embodiment includes providing a substrate in a chamber in a plasma processing apparatus. The substrate includes a silicon-containing film including a silicon oxide film and a mask on the silicon-containing film. The substrate processing method further includes etching the silicon-containing film, in the chamber, with plasma generated from a first process gas containing a hydrogen fluoride gas and at least one carbon-containing gas selected from the group consisting of a C₄F₈ gas, a C₃H₂F₄ gas, and a C₄H₂F₆ gas. The etching includes etching the silicon-containing film with a chemical species contained in the plasma. The hydrogen fluoride gas has a flow rate of 70 to 96 vol% of a total flow rate of non-inert components of the first process gas. The method according to the embodiment improves selectivity in etching of the silicon-containing film over etching of the mask with the plasma generated from the first process gas containing the hydrogen fluoride gas having the flow rate of 70 to 96 vol% of the total flow rate of the non-inert components of the first process gas.

In one exemplary embodiment, the first process gas may further contain at least one selected from the group consisting of an oxygen-containing gas and a halogen-containing gas.

In one exemplary embodiment, the first gas may further contain a phosphorus-containing gas.

A substrate processing method according to still another exemplary embodiment includes providing a substrate in a chamber in a plasma processing apparatus. The substrate includes a silicon-containing film and a mask on the silicon-containing film. The substrate processing method further includes etching the silicon-containing film with plasma generated from a first process gas containing a hydrogen fluoride gas. The etching includes etching the silicon-containing film with a chemical species contained in the plasma. The hydrogen fluoride gas has a flow rate of 70 to 96 vol% of a total flow rate of non-inert components of the first process gas. The method according to the embodiment improves selectivity in etching of the silicon-containing film over etching of the mask with the plasma generated from the first process gas containing the hydrogen fluoride gas having the flow rate of 70 to 96 vol% of the total flow rate of the non-inert components of the first process gas.

In one exemplary embodiment, the first process gas may contain a carbon-containing gas and at least one selected from the group consisting of an oxygen-containing gas, a halogen-containing gas, and a phosphorus-containing gas.

In one exemplary embodiment, the carbon-containing gas may contain at least one selected from the group consisting of a fluorocarbon gas, a hydrofluorocarbon gas, and a hydrocarbon gas.

In one exemplary embodiment, the fluorocarbon gas may include at least one selected from the group consisting of CF₄, C₂F₂, C₂F₄, C₃F₈, C₄F₆, C₄F₈, and C₃F₈.

In one exemplary embodiment, the fluorocarbon gas may include a C₄F₈ gas.

In one exemplary embodiment, the hydrofluorocarbon gas may include at least one selected from the group consisting of CHF₃, CH₂F₂, CH₃F, C₂HF₅, C₂H₂F₄, C₂H₃F₃, C₂H₄F₂, C₃HF₇, C₃H₂F₂, C₃H₂F₆, C₃H₂F₄, C₃H₃F₅, C₄H₅F₅, C₄H₂F₆, C₅H₂F₁₀, and c-C₅H₃F₇.

In one exemplary embodiment, the hydrofluorocarbon gas may include at least one selected from the group consisting of a C₃H₂F₄ gas and a C₄H₂F₆ gas.

In one exemplary embodiment, the hydrocarbon gas may include at least one selected from the group consisting of CH₄, C₂H₆, C₃H₆, C₃H₈, and C₄H₁₀.

In one exemplary embodiment, the carbon-containing gas may include a hydrofluorocarbon gas having three or more carbon atoms.

In one exemplary embodiment, the silicon-containing film may include at least one selected from the group consisting of a film stack including a silicon oxide film and a silicon nitride film, a polysilicon film, a film with a low dielectric constant, and a film stack including a silicon oxide film and a polysilicon film.

In one exemplary embodiment, the mask may include a carbon-containing mask or a metal-containing mask.

In one exemplary embodiment, the substrate processing method may further include, before the etching, adjusting a temperature of the substrate support on which the substrate is placed to 0 °C or lower.

A substrate processing method according to still another exemplary embodiment includes generating plasma from a precoat gas in a chamber in a plasma processing apparatus and depositing a precoat on an inner wall of the chamber. The substrate processing method further includes providing a substrate in the chamber. The substrate includes a silicon-containing film including a silicon oxide film and a mask on the silicon-containing film. The substrate processing method further includes controlling a temperature of a substrate support on which the substrate is placed to 0 °C or lower. The substrate processing method includes etching the silicon-containing film with plasma generated from a process gas containing a hydrogen fluoride gas and at least one carbon-containing gas selected from the group consisting of a fluorocarbon gas and a hydrofluorocarbon gas. The etching includes etching the silicon-containing film with a chemical species contained in the plasma. The hydrogen fluoride gas has a flow rate of at least 70 vol% of a total flow rate of non-inert components of the process gas. The substrate processing method further includes generating plasma from a cleaning gas in the chamber and cleaning an inside of the chamber. The method according to the embodiment improves selectivity in etching of the silicon-containing film over etching of the mask with the plasma generated from the process gas containing the hydrogen fluoride gas having the flow rate of at least 70 vol% of the total flow rate of the non-inert components of the process gas.

A plasma processing apparatus according to still another exemplary embodiment includes a chamber, a substrate support, a plasma generator, and a controller. The chamber has a gas inlet and a gas outlet. The substrate support is configured to support a substrate which is placed thereon in the chamber. The controller causes placing a substrate in the chamber, controlling a temperature of a substrate support, and etching. Placing the substrate in the chamber includes placing the substrate including a silicon-containing film including a silicon oxide film and a mask on the silicon-containing film on the substrate support. Controlling the temperature of the substrate support includes controlling the temperature of the substrate support to 0 °C or lower. The etching includes etching, in the chamber, the silicon-containing film with plasma generated from a first process gas containing a hydrogen fluoride gas and at least one carbon-containing gas selected from the group consisting of a fluorocarbon gas and a hydrofluorocarbon gas. In the etching, the controller controls the hydrogen fluoride gas to have a highest flow rate among non-inert components of the first process gas.

Exemplary embodiments will now be described in detail with reference to the drawings. In the drawings, similar or corresponding components are indicated by like reference numerals. The embodiments are illustrated by way of example and not by way of limitation in the accompanying drawings that are not to scale unless otherwise indicated.

### First Embodiment

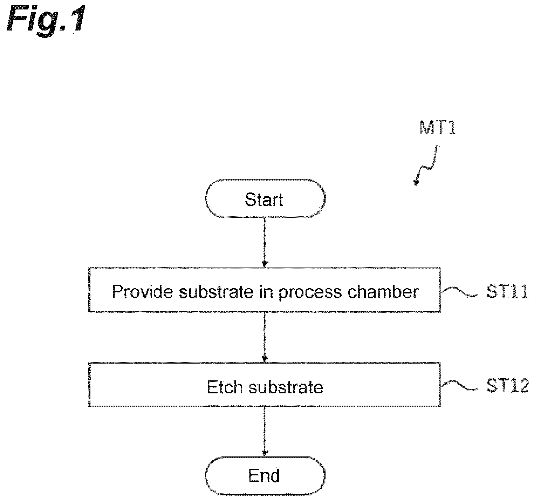

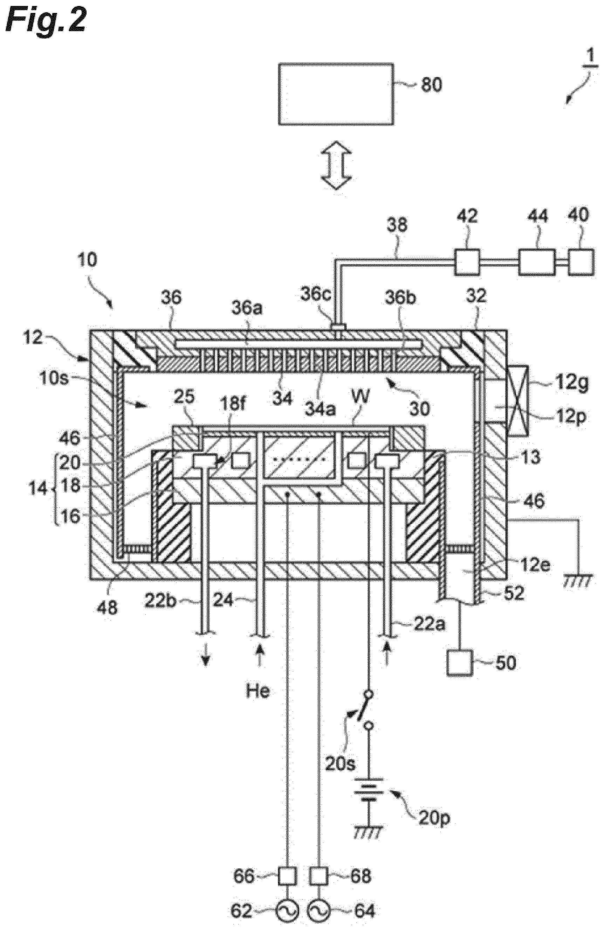

FIG. 1 is a flowchart of an exemplary substrate processing method according to a first embodiment. With a method MT1 shown in FIG. 1, a film containing silicon is etched. The method MT1 may be used in manufacturing, for example, a NAND flash memory with a three-dimensional structure. The method MT1 is used by a plasma processing apparatus. FIG. 2 is a schematic diagram of an exemplary plasma processing apparatus. The method MT1 shown in FIG. 1 may be used by a plasma processing apparatus 1 shown in FIG. 2.

The plasma processing apparatus 1 includes a chamber 10 with an internal space 10s. The chamber 10 includes a chamber body 12, which is substantially cylindrical. The chamber body 12 is formed from, for example, aluminum. The chamber body 12 has inner walls coated with an anticorrosive film, which may be formed from ceramic such as aluminum oxide or yttrium oxide.

The chamber body 12 has a side wall having a port 12p. A substrate W is transferred between the internal space 10s and the outside of the chamber 10 through the port 12p. The port 12p is open and closed by a gate valve 12g that is on the side wall of the chamber body 12.

A support 13 is on the bottom of the chamber body 12. The support 13 is substantially cylindrical and is formed from an insulating material. The support 13 extends upward from the bottom of the chamber body 12 into the internal space 10s. The support 13 includes an upper substrate support 14. The substrate support 14 supports the substrate W in the internal space 10s.

The substrate support 14 includes a lower electrode 18 and an electrostatic chuck (ESC) 20. The substrate support 14 may further include an electrode plate 16. The electrode plate 16 is formed from a conductor such as aluminum and is substantially disk-shaped. The lower electrode 18 is on the electrode plate 16. The lower electrode 18 is formed from a conductor such as aluminum and is substantially disk-shaped. The lower electrode 18 is electrically coupled to the electrode plate 16.

The ESC 20 is on the lower electrode 18. The ESC 20 receives the substrate W on its upper surface. The ESC 20 includes a body and an electrode (chuck electrode). The body of the ESC 20 is substantially disk-shaped and is formed from a dielectric. In the ESC 20, the chuck electrode is a film electrode located in the body. The chuck electrode in the ESC 20 is coupled to a direct-current (DC) power supply 20p via a switch 20s. A voltage is applied from the DC power supply 20p to the chuck electrode in the ESC 20 to generate an electrostatic attraction between the ESC 20 and the substrate W, thus causing the ESC 20 to hold the substrate W. The ESC 20 may have the body including a bias electrode for drawing ions toward the substrate W, in addition to the above chuck electrode. The bias electrode may be a film electrode, similarly to the chuck electrode.

An edge ring 25 is on the periphery of the lower electrode 18 to surround an edge of the substrate W. The edge ring 25 allows more uniform processing across the surface of the substrate W with plasma. The edge ring 25 may be formed from silicon, silicon carbide, or quartz.

The lower electrode 18 has an internal channel 18f for carrying a heat-exchange medium (e.g., refrigerant) being supplied through a pipe 22a from a chiller unit (not shown) external to the chamber 10. The heat-exchange medium being supplied to the channel 18f returns to the chiller unit through a pipe 22b. In the plasma processing apparatus 1, the temperature of the substrate W on the ESC 20 is adjusted through heat exchange between the heat-exchange medium and the lower electrode 18.

The plasma processing apparatus 1 includes a gas supply line 24, which supplies a heat-transfer gas (e.g., He gas) from a heat-transfer gas supply assembly to between the upper surface of the ESC 20 and a back surface of the substrate W.

The plasma processing apparatus 1 further includes an upper electrode 30 that is located above the substrate support 14. The upper electrode 30 is supported on an upper portion of the chamber body 12 with a member 32, which is formed from an insulating material. The upper electrode 30 and the member 32 close a top opening of the chamber body 12.

The upper electrode 30 may include a ceiling plate 34 and a support member 36. The ceiling plate 34 has its lower surface exposed to and defining the internal space 10s. The ceiling plate 34 is formed from a low resistance conductor or a semiconductor that generates less Joule heat. The ceiling plate 34 has multiple gas outlet holes 34a that are through-holes in the thickness direction.

The support member 36 supports the ceiling plate 34 in a detachable manner. The support member 36 is formed from a conductive material such as aluminum. The support member 36 has an internal gas-diffusion compartment 36a. The support member 36 has multiple gas holes 36b that extend downward from the gas-diffusion compartment 36a. The gas holes 36b communicate with the respective gas outlet holes 34a. The support member 36 has a gas inlet 36c. The gas inlet 36c connects to the gas-diffusion compartment 36a. The gas inlet 36c also connects to a gas supply pipe 38.

The gas supply pipe 38 is connected to a set of valves 42, a set of flow controllers 44, and a set of gas sources 40. The gas source set 40, the valve set 42, and the flow controller set 44 form a gas supply unit. The gas source set 40 includes multiple gas sources. The valve set 42 includes multiple open-close valves. The flow controller set 44 includes multiple flow controllers. The flow controllers in the flow controller set 44 are mass flow controllers or pressure-based flow controllers. The gas sources in the gas source set 40 are connected to the gas supply pipe 38 via the respective open-close valves in the valve set 42 and via the respective flow controllers in the flow controller set 44.

The plasma processing apparatus 1 includes a shield 46 along the inner wall of the chamber body 12 and along the periphery of the support 13 in a detachable manner. The shield 46 prevents a reaction product from accumulating on the chamber body 12. The shield 46 includes, for example, an aluminum base coated with an anticorrosive film. The anticorrosive film may be a film of ceramic such as yttrium oxide.

A baffle plate 48 is located between the support 13 and the side wall of the chamber body 12. The baffle plate 48 includes, for example, an aluminum base coated with an anticorrosive film (e.g., yttrium oxide film). The baffle plate 48 has multiple through-holes. The chamber body 12 has a gas outlet 12e in its bottom below the baffle plate 48. The gas outlet 12e connects to an exhaust device 50 through an exhaust pipe 52. The exhaust device 50 includes a pressure control valve and a vacuum pump such as a turbomolecular pump.

The plasma processing apparatus 1 includes a first radio-frequency (RF) power supply 62 and a second RF power supply 64. The first RF power supply 62 generates first RF power. The first RF power has a frequency suitable for generating plasma. The first RF power has a frequency ranging from, for example, 27 to 100 MHz. The first RF power may be a continuous wave or a pulsed wave. The first RF power supply 62 is coupled to the lower electrode 18 via an impedance matching circuit, or matcher 66, and the electrode plate 16. The matcher 66 includes a circuit for matching the output impedance of the first RF power supply 62 and the impedance of a load (the lower electrode 18). The first RF power supply 62 may be coupled to the upper electrode 30 via the matcher 66. The first RF power supply 62 serves as an exemplary plasma generator.

The second RF power supply 64 generates second RF power. The second RF power has a lower frequency than the first RF power. The second RF power, when used in addition to the first RF power, serves as bias RF power for drawing ions toward the substrate W. The second RF power has a frequency ranging from, for example, 400 kHz to 13.56 MHz. The second RF power may be a continuous wave or a pulsed wave. The second RF power supply 64 is coupled to the substrate support 14 via an impedance matching circuit, or matcher 68. In one example, the second RF power supply 64 is coupled to the lower electrode 18 via the matcher 68 and the electrode plate 16. The matcher 68 includes a circuit for matching the output impedance of the second RF power supply 64 and the impedance of a load (the lower electrode 18). The second RF power supply 64 may be coupled to the bias electrode in the ESC 20 via the matcher 68 and the electrode plate 16, similarly to a bias power supply (described later).

The second RF power alone may be used to generate plasma, without the first RF power being used. In other words, a single RF power may be used to generate plasma. In this case, the second RF power may have a frequency higher than 13.56 MHz, or for example, 40 MHz. The plasma processing apparatus 1 may not include the first RF power supply 62 and the matcher 66. The second RF power supply 64 serves as an exemplary plasma generator.

In the present disclosure, the plasma processing apparatus 1 may apply a DC voltage to the upper electrode 30 during the plasma processing. For example, the plasma processing apparatus 1 may apply a pulsed negative DC voltage to the upper electrode 30.

In the plasma processing apparatus 1, the gas supply unit supplies a gas into the internal space 10s to generate plasma. The first RF power and/or the second RF power are provided to form, between the upper electrode 30 and the lower electrode 18, an RF electric field, which then generates plasma.

The plasma processing apparatus 1 may further include a controller 80. The controller 80 may be a computer including a processor, a storage such as a memory, an input device, a display, and an input-output interface for signals. The controller 80 controls the components of the plasma processing apparatus 1. An operator can use the input device in the controller 80 to input a command or perform other operations for managing the plasma processing apparatus 1. The display in the controller 80 can display and visualize the operating state of the plasma processing apparatus 1. The storage stores control programs and recipe data. The control program is executed by the processor to perform the processing in the plasma processing apparatus 1. The processor executes the control program to control the components of the plasma processing apparatus 1 in accordance with the recipe data.

Referring back to FIG. 1, the method MT1 used by the plasma processing apparatus 1 will be described by way of example. As shown in FIG. 1, the method MT1 includes step ST11. In step ST11, a substrate W is provided in the chamber 10 in the plasma processing apparatus 1. The substrate W is placed onto and held by the ESC 20.

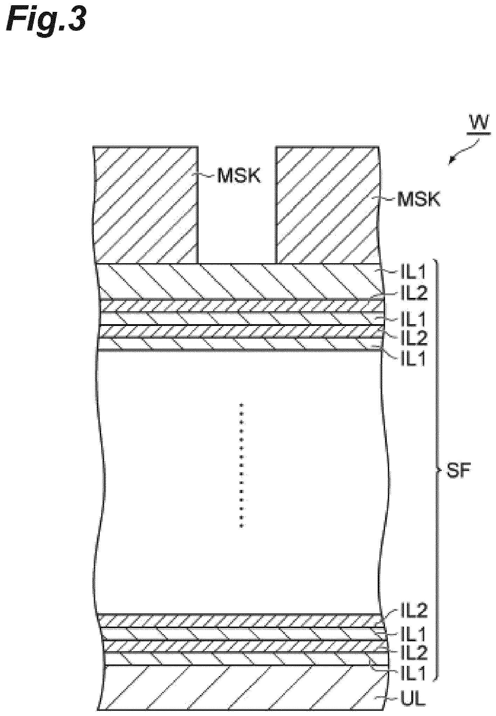

FIG. 3 is a partially enlarged cross-sectional view of an exemplary substrate provided in step ST11 of the method MT1. The substrate W shown in FIG. 3 includes an underlayer UL, a film SF, and a mask MSK. The underlayer UL may be a polycrystalline silicon layer. The film SF contains silicon and is on the underlayer UL. The film SF may be a film stack including one or more silicon oxide films and one or more silicon nitride films. The film SF shown in FIG. 3 is a multilayer including multiple silicon oxide films IL1 and multiple silicon nitride films IL2. The silicon oxide films IL1 and the silicon nitride films IL2 are stacked alternately. The film SF may be another single layer containing silicon or another multilayer containing silicon. The film SF as a single layer may be a low-dielectric-constant film formed from, for example, SiOC, SiOF, or SiCOH, or may be a polysilicon film. The film SF as a multilayer may be a film stack including one or more silicon oxide films and one or more polysilicon films.

The mask MSK is on the film SF and has a pattern for forming a recess such as a hole in the film SF. The mask MSK may be, for example, a hard mask. The mask MSK may be, for example, a carbon-containing mask and/or a metal-containing mask. The carbon-containing mask is formed from, for example, at least one selected from the group consisting of spin-on carbon, tungsten carbide, amorphous carbon, and boron carbide. The metal-containing mask is formed from, for example, at least one selected from the group consisting of titanium nitride, titanium oxide, and tungsten. The mask MSK may be a boron-containing mask formed from, for example, silicon boride, boron nitride, or boron carbide.

As shown in FIG. 1, the method MT1 further includes step ST12, which follows step ST11. In step ST12, plasma is generated from a first process gas in the chamber 10. In step ST12, the film SF is etched with a chemical species contained in the plasma.

The first process gas used in step ST12 contains a hydrogen fluoride gas. The hydrogen fluoride gas has a higher flow rate than other non-inert components of the first process gas. More specifically, in step ST12, the hydrogen fluoride gas may have a flow rate of at least 70 vol%, 80 vol%, 85 vol%, 90 vol%, or 95 vol% of the total flow rate of the non-inert components of the first process gas. When a carbon-containing gas is added to reduce failures such as bowing in the resultant features of the film SF, the hydrogen fluoride gas may have a flow rate of less than 100 vol%, not more than 99.5 vol%, 98 vol%, or 96 vol% of the total flow rate of the non-inert components of the first process gas. In one example, the hydrogen fluoride gas is controlled to have a flow rate of 70 to 96 vol% of the total flow rate of the non-inert components of the first process gas. The flow rate of the hydrogen fluoride gas with respect to the flow rate of the non-inert components of the first process gas is controlled within the above range to allow etching of the film SF at the higher etching rate while less of the mask MSK is being etched. This allows selectivity in etching of the silicon-containing film over etching of the mask to be 5 or greater. The method MT thus enables etching of the film SF at an effective rate in a process for, for example, a NAND flash memory with a three-dimensional structure to achieve a high aspect ratio. Such a high selectivity also reduces the amount of deposition gas to be added, such as a carbon-containing gas. This reduces the possibility of clogging of the mask MSK and shortens the cleaning time in the chamber 10 to 50% or less (described later), greatly improving the throughput of the substrate processing. At the flow rate of the hydrogen fluoride gas less than or equal to the flow rate of other non-inert components of the first process gas, the selectivity cannot be improved sufficiently. The total flow rate of the non-inert components of the first process gas may be controlled as appropriate for the capacity of the chamber, and may be, for example, 100 sccm or more.

The first process gas may include a carbon-containing gas, in addition to the hydrogen fluoride gas. The first process gas may further contain at least one selected from the group consisting of an oxygen-containing gas and a halogen-containing gas, in addition to the hydrogen fluoride gas and the carbon-containing gas.

With the first process gas containing a carbon-containing gas, deposits containing carbon may form on the surface of the mask, thus further improving selectivity in etching of the silicon-containing film over etching of the mask. The carbon-containing gas may contain, for example, at least one selected from the group consisting of a fluorocarbon gas, a hydrofluorocarbon gas, and a hydrocarbon gas. The fluorocarbon gas may be, for example, CF₄, C₂F₂, C₂F₄, C₃F₈, C₄F₆, C₄F₈, or C₅F₈. The hydrofluorocarbon gas may be, for example, CHF₃, CH₂F₂, CH₃F, C₂HF₅, C₂H₂F₄, C₂H₃F₃, C₂H₄F₂, C₃HF₇, C₃H₂F₂, C₃H₂F₆, C₃H₂F₄, C₃H₃F₅, C₄H₅F₅, C₄H₂F₆, C₅H₂F₁₀, c-C₅H₃F₇, or C₃H₂F₄. The hydrocarbon gas may be, for example, CH₄, C₂H₆, C₃H₆, C₃H₈, or C₄H₁₀. The carbon-containing gas containing any of the above gases may further contain CO and/or CO₂. In one example, the carbon-containing gas may be a fluorocarbon gas and/or a hydrofluorocarbon gas having two or more carbon atoms. The fluorocarbon gas and/or a hydrofluorocarbon gas having two or more carbon atoms can effectively reduce feature failures, such as bowing. A fluorocarbon gas and/or a hydrofluorocarbon gas having three or more carbon atoms can further reduce feature failures. The fluorocarbon gas having three or more carbon atoms may be, for example, C₄F₈. The hydrofluorocarbon gas having three or more carbon atoms may have an unsaturated bond and may contain one or more CF₃ groups. The hydrofluorocarbon gas having three or more carbon atoms may be, for example, C₃H₂F₄ or C₄H₂F₆.

With the first process gas containing an oxygen-containing gas, the opening in the mask is less likely to be closed during etching. The oxygen-containing gas may contain, for example, at least one selected from the group consisting of O₂, CO, CO₂, H₂O, and H₂O₂.

With the first process gas containing a halogen-containing gas, the etched features can be controlled. The halogen-containing gas may be, for example, at least one selected from the group consisting of a carbon-free fluorine-containing gas such as SF₆, NF₃, XeF₂, SiF₄, IF₇, ClF₅, BrF₅, AsF₅, NF₅, PF₃, PF₅, POF₃, BF₃, HPF₆, or WF₆; a chlorine-containing gas such as Cl₂, SiCl₂, SiCl₄, CCl₄, BCl₃, PCl₃, PCl₅, or POCl₃; a bromine-containing gas such as HBr, CBr₂F₂, C₂F₅Br, PBr₃, PBr₅, or POBr₃; and an iodine-containing gas such as HI, CF₃I, C₂F₅I, C₃F₇I, IF₅, IF₇, I₂, or PI₃.

In addition to any of the above gas species, the first process gas may contain a gas that effectively protects the side wall, or specifically, a sulfur-containing gas such as COS; a phosphorus-containing gas such as P₄O₁₀, P₄O₈, P₄O₆, PH₃, Ca₃P₂, H₃PO₄, or Na₃PO₄; or a boron-containing gas such as B₂H₆. The phosphorus-containing gas that effectively protects the side wall further includes phosphorus halide gases including a phosphorus fluoride gas such as PF₃ or PF₅ described above and a phosphorus chloride gas such as PCl₃ or PCl₅.

In one exemplary embodiment of the present disclosure, the first process gas contains a hydrogen fluoride gas and at least one carbon-containing gas selected from the group consisting of a fluorocarbon gas and a hydrofluorocarbon gas. The carbon-containing gas may be the fluorocarbon gas described above or the hydrofluorocarbon gas described above. The fluorocarbon gas may be C₄F₈. The hydrofluorocarbon gas may be at least one selected from the group consisting of C₃H₂F₄ and C₄H₂F₆.

In an exemplary embodiment, the first process gas may further contain at least one selected from the group consisting of an oxygen-containing gas and a halogen-containing gas. In this case, the halogen-containing gas may be at least one selected from the group consisting of a halogen-containing gas containing a halogen element other than fluorine and a carbon-free fluorine-containing gas.

In an exemplary embodiment, the first process gas may further contain, as an additive gas, at least one selected from the group consisting of a sulfur-containing gas, a phosphorus-containing gas, and a boron-containing gas that can effectively protect the side wall.

In addition to any of the above gas species, the first process gas may also contain an inert gas, or more than one inert gas. The inert gas(es) may contain a noble gas such as Ar, Kr, or Xe, or a nitrogen gas. In the first process gas, the ratio of the flow rate of the hydrogen fluoride gas with respect to the total flow rate of the non-inert components of the first process gas is controlled within the range specified above.

To perform the processing in step ST12, the controller 80 controls the gas supply unit to supply the above process gas into the chamber 10. To perform the processing in step ST12, the controller 80 controls the gas supply unit to supply the process gas containing the hydrogen fluoride gas with the flow rate being at least 70 vol% of the total flow rate of the process gas into the chamber 10. To perform the processing in step ST12, the controller 80 controls the exhaust device 50 to maintain the chamber 10 at a specified pressure. To perform the processing in step ST12, the controller 80 controls the first RF power supply 62 and/or the second RF power supply 64 to provide the first RF power and/or the second RF power to generate plasma from the process gas in the chamber 10.

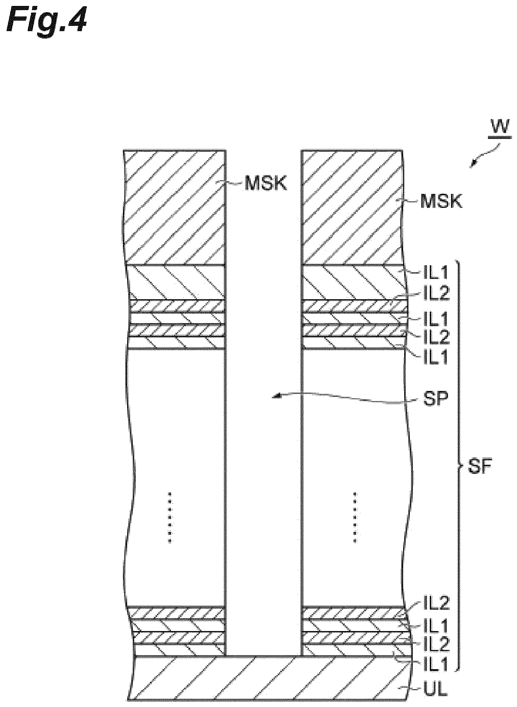

In step ST12, the second RF power supply 64 may provide second RF power (in other words, bias RF power) of at least 5 W/cm² to the substrate support 14 to draw ions in the plasma toward the substrate W. With the second RF power of at least 5 W/cm², ions in the plasma can readily reach the bottom of a recess in the film SF formed through etching (e.g., a recess SP in FIG. 4).

A pulsed voltage other than the RF power may be applied to the substrate support 14 instead of the bias RF power. The pulsed voltage herein refers to a pulsed voltage applied from a pulse power supply. The pulse power supply may provide pulsed waves or may include a device for pulsing the voltage downstream from the pulse power supply. In one example, a pulsed voltage is applied to the substrate support 14 to cause the substrate W to have a negative potential. The pulsed voltage may be a pulsed negative DC voltage. The pulsed voltage may have a square wave pulse, a triangular wave pulse, an impulse, or any other voltage waveform pulse.

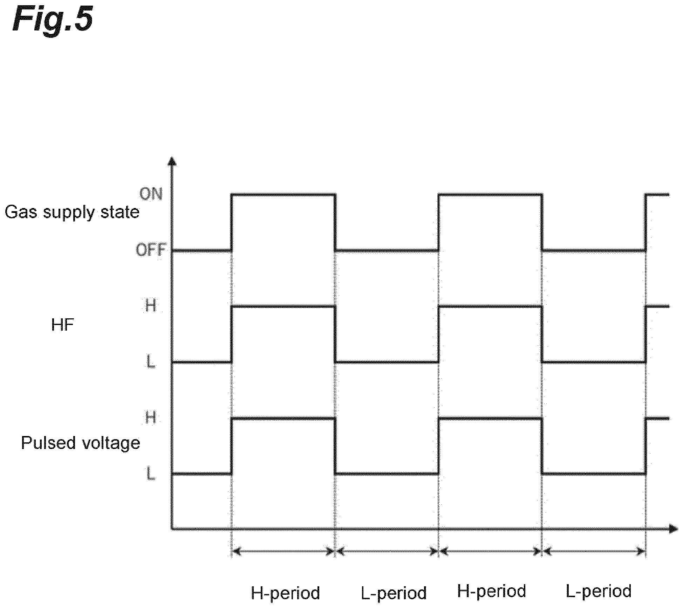

FIG. 5 shows a timing chart of a substrate processing method according to an exemplary embodiment. In FIG. 5, the horizontal axis indicates time. In FIG. 5, the vertical axis indicates the supply state of the first process gas, the level of the first RF power HF, and the level of the pulsed voltage. In FIG. 5, the first process gas is periodically supplied into the chamber 10. The pulsed first RF power and the pulsed voltage are also periodically provided to the substrate support 14. The period in which the pulsed first RF power HF is provided, the period in which the pulsed voltage is applied, and the period in which the first process gas is supplied are synchronized. The first process gas may be continuously supplied into the chamber 10.

In FIG. 5, the level L of the first RF power HF indicates that the first RF power HF is not provided or the power level of the first RF power HF is lower than the power level indicated by H. The level L of the pulsed voltage indicates that the pulsed voltage is not applied to the substrate support 14 or the level of the pulsed voltage is lower than the level indicated by H. The supply state ON of the first process gas indicates that the first process gas is supplied into the chamber 10. The supply state OFF of the first process gas indicates that the supply of the first process gas into the chamber 10 is stopped. The period with the pulsed voltage at the L voltage level is herein referred to as an L-period, and the period with the pulsed voltage at the H voltage level is referred to as an H-period.

The frequency of the pulsed voltage in the H period (first frequency) may be controlled to 100 kHz to 3.2 MHz. In one example, the first frequency is controlled to 400 kHz. In this case, the duty cycle indicating the percentage of the period in which the pulsed voltage is at the H level within one cycle (first duty ratio) may be 50% or less, or 30% or less.

The frequency of the pulsed voltage periodically applied, or the frequency that defines the cycles of the H periods (second frequency), may be 1 kHz to 200 kHz or 5 Hz to 100 kHz. In this case, the duty cycle indicating the percentage of the H period within one cycle (second duty ratio) may be 50 to 90%.

Although the period in which the pulsed first RF power HF is provided, the period in which the pulsed voltage is applied, and the period in which the first process gas is supplied are synchronized in the exemplary embodiment, these periods may not be synchronized.

The ESC 20 may be at any temperature in step ST12. However, the ESC 20 may be adjusted to a lower temperature of, for example, 0 °C or lower, or -50 °C or lower before step ST12 is started to facilitate adsorption of the etchant on the substrate surface, thus improving the etching rate. When the first process gas includes a phosphorus-containing gas, the ESC 20 may be adjusted to a temperature of 50 °C or lower, 30 °C or lower, or 20 °C or lower, depending on the ratio of the phosphorus-containing gas in the first process gas.

When the processing in step ST12 is complete, the method MT1 completes. FIG. 4 is a partially enlarged cross-sectional view of the substrate after being processed with the substrate processing method shown in FIG. 1. With the method MT1, the recess SP may extend through the film SF and reach the underlayer UL as shown in FIG. 4.

### First Experiment

The results of a first experiment conducted for evaluating the method MT1 will now be described. In the first experiment, eight sample substrates identical to the substrate W shown in FIG. 3 were prepared. In the first experiment, the film SF in each of the eight sample substrates underwent plasma etching using the plasma processing apparatus 1. The plasma etching was conducted using a first process gas containing a fluorocarbon gas, a hydrofluorocarbon gas, a carbon-free fluorine-containing gas, and a halogen-containing gas. The first sample substrate, among the eight sample substrates, underwent plasma etching using a first process gas containing no hydrogen fluoride gas. The second to eighth sample substrates, among the eight sample substrates, each underwent plasma etching using a first process gas containing a hydrogen fluoride gas having a flow rate varying from 34.2 vol%, 51.0 vol%, 80.0 vol%, 95.2 vol%, 98.8 vol%, 99.5 vol%, and to 100 vol% with respect to the total flow rate of the first process gas. In the first experiment, the ESC 20 that receives each sample substrate is adjusted to a temperature of -50 °C or lower before the plasma etching is started.

In the first experiment, the selectivity in etching of the films SF over etching of the mask MSK was determined based on the resultant films SF after plasma etching in the eight sample substrates. More specifically, the selectivity was determined by dividing the etching rate of the film SF by the etching rate of the mask MSK based on the resultant film SF after plasma etching in each of the eight sample substrates.

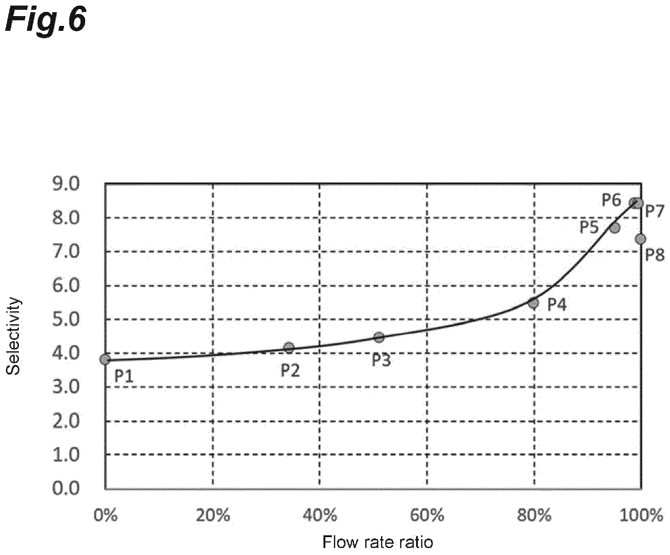

FIG. 6 is a graph showing the results of the first experiment conducted for evaluating the substrate processing method shown in FIG. 1. In the graph of FIG. 6, the horizontal axis indicates the flow rate ratio. The flow rate ratio refers to the ratio (vol%) of the flow rate of the hydrogen fluoride gas with respect to the total flow rate of the non-inert components of the first process gas. In the graph of FIG. 6, the vertical axis indicates selectivity. In FIG. 6, plots P1 to P8 indicate selectivity determined from the resultant films SF after plasma etching performed on the first to the eighth sample substrates.

As shown in FIG. 6, the results of the first experiment reveal that the selectivity increases as the ratio (hereinafter referred to as the flow rate ratio) of the flow rate of the hydrogen fluoride gas with respect to the total flow rate of the non-inert components of the first process gas increases. In particular, the selectivity increases more (the gradient is steeper in the graph of FIG. 6) at the flow rate ratios of at least 80 vol% than at the flow rate ratios of less than 80 vol%. This may be explained as follows. At the flow rate ratios of less than 80 vol%, the silicon-containing film is etched at a higher etching rate for a higher flow rate ratio, thus increasing the selectivity. However, the mask is also etched by a certain degree in this range. The selectivity thus increases relatively slowly. At the flow rate ratios of at least 80 vol%, the silicon-containing film is likely to be etched at a saturated etching rate, but the mask is etched at a lower etching rate. The selectivity thus increases. More specifically, at the flow rate ratios of at least 80 vol%, the silicon-containing film remains etched at a higher etching rate but almost no portion of the mask is etched. The selectivity thus increases at a higher rate.

As shown in FIG. 6, when the hydrogen fluoride gas has a flow rate of at least 70 vol% of the total flow rate of the non-inert components of the first process gas, the selectivity is 5 or greater. In particular, when the hydrogen fluoride gas has a flow rate of at least 90 vol% of the total flow rate of the non-inert components of the first process gas, the selectivity is 7 or greater. When the flow rate ratio is at least 95 vol%, the selectivity is 7.5 or greater.

### Second Experiment

In a second experiment, three sample substrates identical to the substrate W shown in FIG. 3 were prepared. In the second experiment, the film SF in each of the three sample substrates underwent plasma etching using the plasma processing apparatus 1. The plasma etching uses a first process gas containing a hydrogen fluoride gas and a carbon-containing gas. For the ninth sample substrate, a first process gas containing a hydrogen fluoride gas and a fluorocarbon gas was used. For the tenth sample substrate, a first process gas containing a hydrogen fluoride gas and a hydrofluorocarbon gas having one carbon atom was used. For the eleventh sample substrate, a first process gas containing a hydrogen fluoride gas and a hydrofluorocarbon gas having four carbon atoms was used. In the second experiment, the ESC 20 that receives each sample substrate is adjusted to a temperature of -50 °C or lower before the plasma etching is started.

In the second experiment, the selectivity in etching of the films SF over etching of the mask MSK was determined based on the resultant films SF after plasma etching in the three sample substrates. More specifically, the selectivity was determined by dividing the etching rate of the film SF by the etching rate of the mask MSK based on the resultant film SF after plasma etching in each of the three sample substrates.

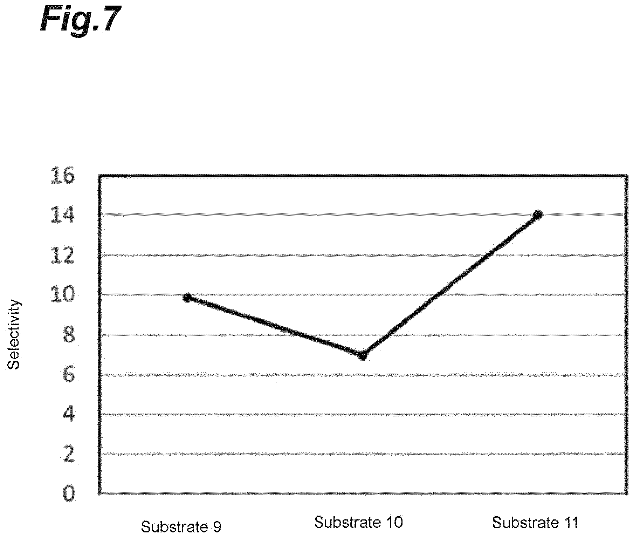

FIG. 7 is a graph showing the results of the second experiment. In the graph of FIG. 7, the horizontal axis indicates the sample substrates. In the graph of FIG. 7, the vertical axis indicates selectivity for substrates 9 to 11 determined from the resultant films SF after plasma etching performed on the ninth to the eleventh sample substrates.

As shown in FIG. 7, the results of the second experiment reveal that the selectivity is greater than 6 for all the sample substrates. In particular, the results reveal that the eleventh sample substrate processed using a hydrofluorocarbon gas having four carbon atoms has a selectivity of about 14, which is the highest of the three sample substrates.

### Third and Fourth Experiments

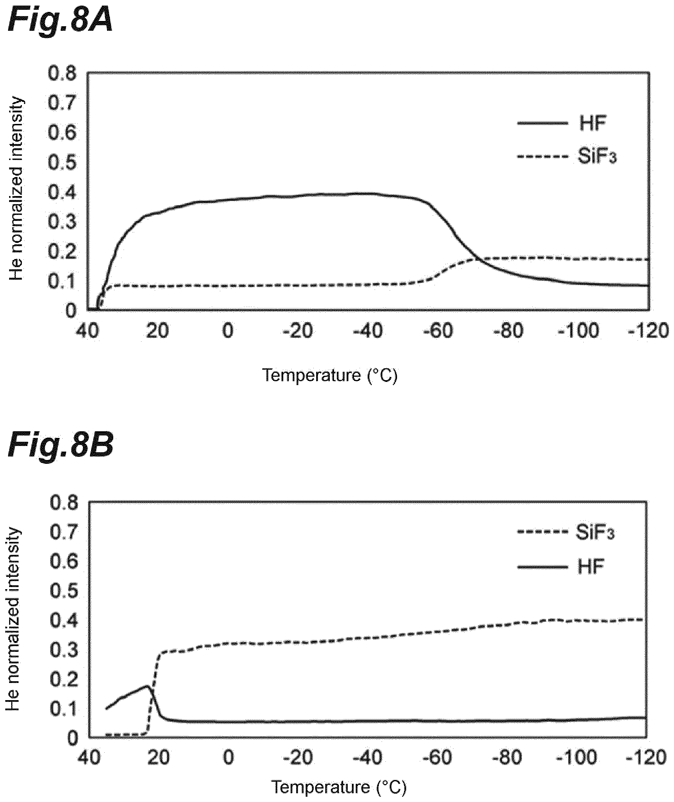

In a third experiment, a silicon oxide film is etched with plasma generated from a process gas, which is a mixture of a hydrogen fluoride gas and an argon gas using the plasma processing apparatus 1. In a fourth experiment, a silicon oxide film is etched with plasma generated from a process gas, which is a mixture of a hydrogen fluoride gas, an argon gas, and a PF₃ gas using the plasma processing apparatus 1. In the third and fourth experiments, the silicon oxide films were etched at varying temperatures of the ESC 20. In the third and fourth experiments, the amounts of hydrogen fluoride (HF) and SiF₃ in the gas phase during the etching of the silicon oxide film were measured using a quadrupole mass spectrometer. FIGs. 8A and 8B show the results of the third and fourth experiments. FIG. 8A shows the relationship between the temperature of the ESC 20 and the amounts of HF and SiF₃ during the etching of the silicon oxide film in the third experiment. FIG. 8B shows the relationship between the temperature of the ESC 20 and the amounts of HF and SiF₃ during the etching of the silicon oxide film in the fourth experiment.

As shown in FIG. 8A, when the temperature of the ESC 20 is about -60 °C or lower, the amount of HF, which is an etchant, decreases and the amount of SiF₃, which is a reaction product through the etching of the silicon oxide film, increases in the third experiment. More specifically, when the temperature of the ESC 20 is about -60 °C or lower, the amount of etchant used in the silicon oxide film etching increases in the third experiment. As shown in FIG. 8B, when the temperature of the ESC 20 is 20 °C or lower, the amount of HF decreases and the amount of SiF₃ increases in the fourth experiment. More specifically, when the temperature of the ESC 20 is 20 °C or lower, the amount of etchant used in the silicon oxide film etching increases in the fourth experiment. The process gas used in the fourth experiment differs from the process gas used in the third experiment in containing a PF₃ gas. In the fourth experiment, a phosphorus chemical species formed on the surface of the silicon oxide film during etching. This reveals that the adsorption of the etchant on the silicon oxide film is facilitated when the phosphorus chemical species forms on the surface of the silicon oxide film, despite the relatively high temperature of at least 20°C of the ESC 20. The etching rate of the silicon-containing film thus increases with the increased supply amount of etchant to the bottom of the opening (recess) when the phosphorus chemical species forms on the surface of the substrate.

### Second Embodiment

With the substrate processing method according to the first embodiment, increasing amounts of reaction product accumulate on the inner walls of the chamber 10 or on the substrate support 14 as the processing is performed over a repeated number of times. As more reaction product accumulates, the processing environment changes, possibly affecting uniformity in the processing across substrates W. As more reaction product accumulates, particles may also form. The inside of the chamber is cleaned with plasma generated from a cleaning gas.

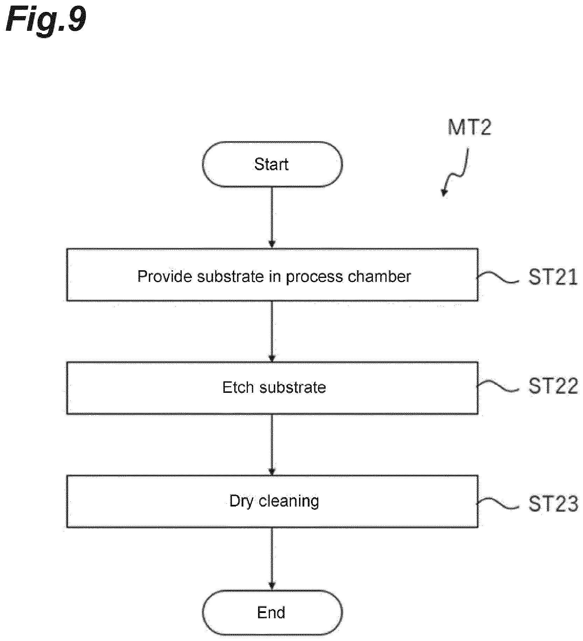

FIG. 9 is a flowchart of an exemplary substrate processing method according to a second embodiment. With a method MT2 shown in FIG. 9, a silicon-containing film is etched, as with the method MT1. Steps ST21 and ST22 are identical to steps ST11 and ST12 included in the method MT1 described above, and will not be described.

As shown in FIG. 9, the method MT2 further includes step ST23, which follows step ST22. In step ST23, plasma is generated from a second process gas (a cleaning gas) in the chamber 10. In step ST23, the inside of the chamber 10 is cleaned with a chemical species contained in the plasma. The processing time of step ST23 is normally determined by monitoring the state of plasma emission. The method according to the second embodiment shortens the cleaning time to 50% or less of the cleaning time with known processing and improves the throughput of the substrate processing.

The second process gas used in step ST23 may contain, for example, at least one selected from the group consisting of a fluorine-containing gas, an oxygen-containing gas, a hydrogen-containing gas, and a nitrogen-containing gas. The fluorine-containing gas may be, for example, CF₄, SF₆, or NF₃. The oxygen-containing gas may be, for example, O₂, CO, CO₂, H₂O, or H₂O₂. The hydrogen-containing gas may be, for example, H₂ or HCl. The nitrogen-containing gas may be, for example, N₂. In addition to any of the above gas species, the second process gas may further contain a noble gas such as Ar.

Step ST23 may be performed after each substrate W is processed or after either a predetermined number of substrates W or substrates W with a predetermined number of lots are processed. In some embodiments, step ST23 may be performed after the substrate processing is performed for a predetermined time.

### Third Embodiment

In the first and second embodiments, the first process gas contains a hydrogen fluoride gas. The hydrogen fluoride gas is highly corrosive. Thus, the inner walls of the chamber 10 may be coated with a precoat before the etching processing is performed. In particular, when the first process gas contains a high concentration of the hydrogen fluoride gas, the inner walls of the chamber 10 may be coated with a precoat to reduce corrosion of the inner walls. This reduces the frequency of maintenance. The inner walls of the chamber 10 include the side wall and the ceiling (the ceiling plate 34 of the upper electrode 30) of the chamber 10, and the substrate support 14.

The precoat may be formed of a silicon-containing film such as a silicon oxide film, or a material of the same type as the material of the mask MSK. When the mask MSK is a carbon-containing mask, the precoat may be formed of a carbon-containing material. The carbon-containing material include, for example, at least one selected from the group consisting of spin-on carbon, tungsten carbide, amorphous carbon, and boron carbide. When the mask MSK is a metal-containing mask, the precoat may be formed of a metal-containing material. The metal-containing material includes, for example, at least one selected from the group consisting of titanium nitride, titanium oxide, and tungsten. When the mask MSK is a boron-containing mask, the precoat is formed of a boron-containing material. The boron-containing material include, for example, at least one selected from the group consisting of silicon borohydride, boron nitride, and boron carbide.

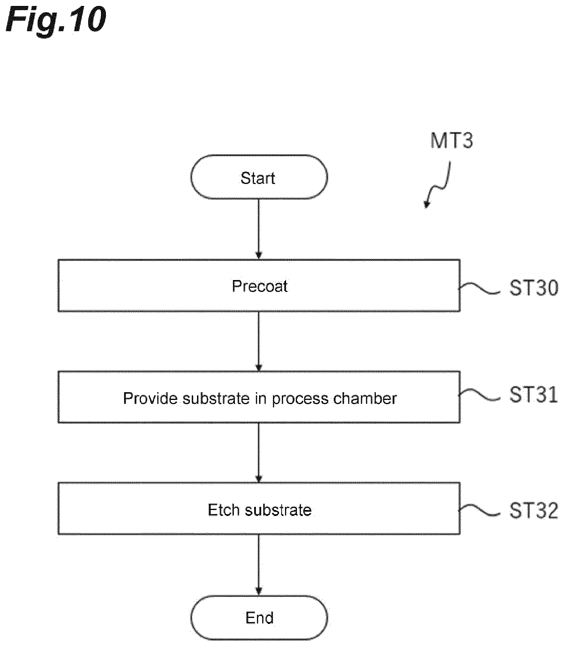

FIG. 10 is a flowchart of an exemplary substrate processing method according to a third embodiment. With a method MT3 shown in FIG. 10, a silicon-containing film is etched, as with the method MT1. Steps ST31 and ST32 are identical to steps ST11 and ST12 included in the method MT1 described above, and will not be described.

As shown in FIG. 10, the method MT3 further includes step ST30, which is followed by step ST31. In step ST30, plasma is generated from a third process gas (a precoat gas) in the chamber 10. In step ST30, the inner walls of the chamber 10 are coated with a precoat formed from a chemical species contained in the plasma.

The precoat may be deposited using the third process gas through chemical vapor deposition (CVD) or atomic layer deposition (ALD). When a precoat is a silicon oxide film, the third process gas may be a silicon-containing gas such as SiCl₄ or an aminosilane gas or may be an oxygen-containing gas such as O₂. When a precoat is a carbon film, the third process gas may be a carbon-containing gas such as CH₄ or C₂H₂.

Step ST30 may be performed after each substrate W is processed, or after either a predetermined number of substrates W or substrates W with a predetermined number of lots are processed. In some embodiments, step ST30 may be performed after the substrate processing is performed for a predetermined time.

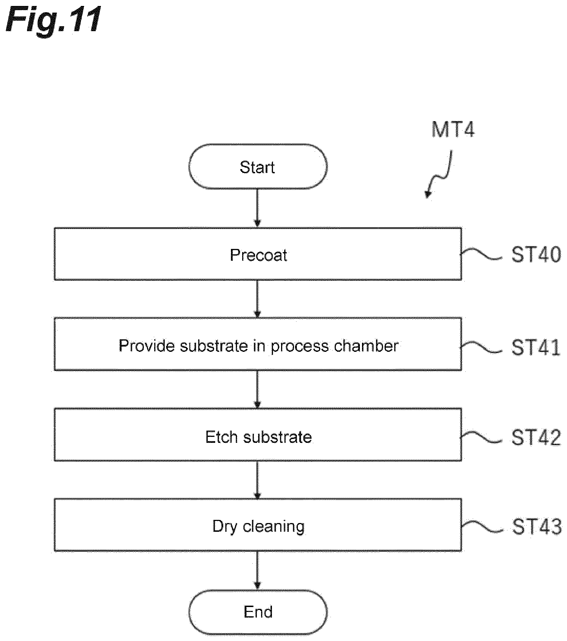

The process for depositing the precoat may be combined with a cleaning process as described for the substrate processing method shown in FIG. 11 according to a modification of the third embodiment. The modification can reduce both production of particles and corrosion of the inner walls of the chamber 10.

Although the exemplary embodiments have been described above, the embodiments are not restrictive, and various omissions, substitutions, and changes may be made. The components in the different exemplary embodiments may be combined to form another exemplary embodiment.

The plasma processing apparatus that uses the methods MT1 to MT4 may be a plasma processing apparatus different from the plasma processing apparatus 1. The plasma processing apparatus that uses the methods MT1 to MT4 may be another capacitively coupled plasma processing apparatus, an inductively coupled plasma processing apparatus, or a plasma processing apparatus that generates plasma using surface waves such as microwaves.

As described above, the hydrogen fluoride gas is highly corrosive. The flow rate ratio of the hydrogen fluoride gas or the type of gas to be added to the first process gas may be changed as appropriate as the processing is performed in stages. For example, the flow rate ratio of the hydrogen fluoride gas in the final stage of the etching that may not need to retain the mask thickness may be controlled to be lower than the flow rate ratio of the hydrogen fluoride gas in the initial to intermediate stages of etching that needs to retain the mask thickness. In other examples, in etching of an area with a low aspect ratio that is likely to have failures, such as bowing, in the resultant features, the flow rate ratio of a gas that effectively protects the side wall may be increased more than the flow rate ratio of the gas used in etching of an area with a high aspect ratio. The etched features may be monitored using an optical observation device. The flow rate ratio of the hydrogen fluoride gas, or the type of gas added to the first process gas or its flow rate ratio may also be changed in accordance with the etched features.

The above embodiments also include the aspects described below.

### Appendix 1

A substrate processing method, comprising:
providing a substrate in a chamber, the substrate including a silicon-containing film including a silicon oxide film and a mask on the silicon-containing film;
controlling a temperature of a substrate support on which the substrate is placed to 0 °C or lower; and
etching the silicon-containing film, in the chamber, with plasma generated from a first process gas containing a hydrogen fluoride gas and at least one carbon-containing gas selected from the group consisting of a C₄F₈ gas, a C₃H₂F₄ gas, and a C₄H₂F₆ gas,
wherein the hydrogen fluoride gas has a highest flow rate among non-inert components of the first process gas.

### Appendix 2

The substrate processing method according to appendix 1, wherein
the first process gas further contains at least one additive gas selected from the group consisting of an oxygen-containing gas, a halogen-containing gas, and a phosphorus-containing gas.

### Appendix 3

An etching gas composition, comprising:
a hydrogen fluoride gas; and
at least one carbon-containing gas selected from the group consisting of a fluorocarbon gas and a hydrofluorocarbon gas,
wherein the hydrogen fluoride gas has a flow rate of at least 70 vol% of a total flow rate of non-inert components of the etching gas composition.

### Appendix 4

The etching gas composition according to appendix 3, wherein
the fluorocarbon gas includes at least one selected from the group consisting of CF₄, C₂F₂, C₂F₄, C₃F₈, C₄F₆, C₄F₈, and C₅F₈.

### Appendix 5

The etching gas composition according to appendix 3, wherein
the fluorocarbon gas includes a C₄F₈ gas.

### Appendix 6

The etching gas composition according to appendix 3, wherein
the hydrofluorocarbon gas includes at least one selected from the group consisting of CHF₃, CH₂F₂, CH₃F, C₂HF₅, C₂H₂F₄, C₂H₃F₃, C₂H₄F₂, C₃HF₇, C₃H₂F₂, C₃H₂F₆, C₃H₂F₄, C₃H₃F₅, C₄H₅F₅, C₄H₂F₆, C₅H₂F₁₀, c-C₅H₃F₇, and C₃H₂F₄.

### Appendix 7

The etching gas composition according to appendix 3, wherein
the hydrofluorocarbon gas includes at least one selected from the group consisting of a C₃H₂F₄ gas and a C₄H₂F₆ gas.

### Appendix 8

The etching gas composition according to any one of appendixes 3 to 7, further comprising:
at least one selected from the group consisting of an oxygen-containing gas and a halogen-containing gas.

### Appendix 9

The etching gas composition according to any one of appendixes 3 to 8, further comprising:
at least one selected from the group consisting of a phosphorus-containing gas, a sulfur-containing gas, and a boron-containing gas.

### Appendix 10

The etching gas composition according to any one of appendixes 3 to 9, wherein
the hydrogen fluoride gas has a flow rate of not more than 96 vol% of the total flow rate of the non-inert components of the first process gas.

### Appendix 11

A hydrogen fluoride gas to be contained in the etching gas composition according to any one of appendixes 3 to 10.

The exemplary embodiments according to the present disclosure have been described by way of example, and various changes may be made without departing from the scope and spirit of the present disclosure. The exemplary embodiments disclosed above are thus not restrictive, and the true scope and spirit of the present disclosure is defined by the appended claims.

Some further aspects of the invention can be found in the following paragraphs:
1. A substrate processing method, comprising:
   providing a substrate in a chamber, the substrate including a silicon-containing film including a silicon oxide film and a mask on the silicon-containing film;
   controlling a temperature of a substrate support on which the substrate is placed to 0 °C or lower; and
   etching the silicon-containing film with plasma generated from a first process gas containing a hydrogen fluoride gas and at least one carbon-containing gas selected from the group consisting of a fluorocarbon gas and a hydrofluorocarbon gas,
   wherein the hydrogen fluoride gas has a highest flow rate among non-inert components of the first process gas.
2. The substrate processing method according to paragraph 1, wherein
   the hydrogen fluoride gas has a flow rate of at least 70 vol% of a total flow rate of the non-inert components of the first process gas.
3. The substrate processing method according to paragraph 1 or 2, wherein
   the fluorocarbon gas includes at least one selected from the group consisting of CF₄, C₂F₂, C₂F₄, C₃F₈, C₄F₆, C₄F₈, and C₅F₈.
4. The substrate processing method according to paragraph 1 or 2, wherein
   the fluorocarbon gas includes a C₄F₈ gas.
5. The substrate processing method according to paragraph 1 or 2, wherein
   the hydrofluorocarbon gas includes at least one selected from the group consisting of CHF₃, CH₂F₂, CH₃F, C₂HF₅, C₂H₂F₄, C₂H₃F₃, C₂H₄F₂, C₃HF₇, C₃H₂F₂, C₃H₂F₆, C₃H₂F₄, C₃H₃F₅, C₄H₅F₅, C₄H₂F₆, C₅H₂F₁₀ and c-C₅H₃F₇.
6. The substrate processing method according to paragraph 1 or 2, wherein
   the hydrofluorocarbon gas includes at least one selected from the group consisting of a C₃H₂F₄ gas and a C₄H₂F₆ gas.
7. The substrate processing method according to paragraphs 1 to 6, wherein
   the first process gas further contains at least one selected from the group consisting of an oxygen-containing gas and a halogen-containing gas.
8. The substrate processing method according to paragraphs 1 to 7, wherein
   the first process gas further contains at least one selected from the group consisting of a phosphorus-containing gas, a sulfur-containing gas, and a boron-containing gas.
9. The substrate processing method according to paragraphs 1 to 8, wherein
   the hydrogen fluoride gas has a flow rate of not more than 96 vol% of a total flow rate of the non-inert components of the first process gas.
10. The substrate processing method according to paragraphs 1 to 9, wherein
   the silicon-containing film includes at least one selected from the group consisting of a silicon oxide film, a film stack including a silicon oxide film and a silicon nitride film, and a film stack including a silicon oxide film and a polysilicon film.
11. The substrate processing method according to paragraphs 1 to 10, wherein
   the mask includes a carbon-containing mask or a metal-containing mask.
12. The substrate processing method according to paragraph 11, wherein
   the carbon-containing mask comprises at least one selected from the group consisting of spin-on carbon, tungsten carbide, amorphous carbon, and boron carbide.
13. The substrate processing method according to paragraphs 1 to 12, further including
   generating plasma from a second process gas in the chamber and cleaning an inside of the chamber.
14. The substrate processing method according to paragraph 13, wherein
   the second process gas contains at least one selected from the group consisting of a fluorine-containing gas, an oxygen-containing gas, a hydrogen-containing gas, and a nitrogen-containing gas.
15. The substrate processing method according to paragraphs 1 to 14, further including
   generating plasma from a third process gas in the chamber before the providing the substrate and depositing a precoat on an inner wall of the chamber.
16. The substrate processing method according to paragraph 15, wherein
   the third process gas contains a carbon-containing gas.
17. A substrate processing method, comprising:
   providing a substrate in a chamber, the substrate including a silicon-containing film and a mask on the silicon-containing film; and
   etching the silicon-containing film with plasma generated from a first process gas containing a hydrogen fluoride gas,
   wherein the hydrogen fluoride gas has a flow rate of 70 to 96 vol% of a total flow rate of non-inert components of the first process gas.
18. The substrate processing method according to paragraph 17, wherein
   the first process gas further contains a carbon-containing gas and at least one selected from the group consisting of an oxygen-containing gas and a halogen-containing gas.
19. The substrate processing method according to paragraph 18, wherein
   the carbon-containing gas contains at least one selected from the group consisting of a fluorocarbon gas, a hydrofluorocarbon gas, and a hydrocarbon gas.
20. The substrate processing method according to paragraph 19, wherein
   the fluorocarbon gas includes at least one selected from the group consisting of CF₄, C₂F₂, C₂F₄, C₃F₈, C₄F₆, C₄F₈, and C₅F₈.
21. The substrate processing method according to paragraph 19, wherein
   the hydrofluorocarbon gas includes at least one selected from the group consisting of CHF₃, CH₂F₂, CH₃F, C₂HF₅, C₂H₂F₄, C₂H₃F₃, C₂H₄F₂, C₃HF₇, C₃H₂F₂, C₃H₂F₆, C₃H₂F₄, C₃H₃F₅, C₄H₅F₅, C₄H₂F₆, C₅H₂F₁₀, and c-C₅H₃F₇.
22. The substrate processing method according to paragraph 19, wherein
   the hydrocarbon gas includes at least one selected from the group consisting of CH₄, C₂H₆, C₃H₆, C₃H₈, and C₄H₁₀.
23. The substrate processing method according to paragraph 18, wherein
   the carbon-containing gas includes a hydrofluorocarbon gas having three or more carbon atoms.
24. The substrate processing method according to paragraphs 17 to 23, wherein
   the silicon-containing film includes at least one selected from the group consisting of a film stack including a silicon oxide film and a silicon nitride film, a polysilicon film, a film with a low dielectric constant, and a film stack including a silicon oxide film and a polysilicon film.
25. The substrate processing method according to paragraphs 17 to 24, wherein
   the mask includes a carbon-containing mask or a metal-containing mask.
26. The substrate processing method according to paragraphs 17 to 25, further including
   controlling a temperature of a substrate support on which the substrate is placed to 0 °C or lower before the etching.
27. A plasma processing apparatus comprising,
   a chamber having a gas inlet and a gas outlet;
   a substrate support configured to support a substrate which is placed thereon in the chamber;
   a plasma generator; and
   a controller configured to cause
      placing the substrate on the substrate support, the substrate including a silicon-containing film including a silicon oxide film and a mask on the silicon-containing film,
      controlling a temperature of the substrate support to 0 °C or lower, and
      etching the silicon-containing film with plasma generated from a first process gas containing a hydrogen fluoride gas and at least one carbon-containing gas selected from the group consisting of a fluorocarbon gas and a hydrofluorocarbon gas,
   wherein the hydrogen fluoride gas has a highest flow rate among non-inert components of the first process gas.

## Claims

1. A plasma processing apparatus comprising,
a chamber having a gas inlet and a gas outlet;
a plasma generator; and
a controller configured to cause
placing a substrate in the chamber, the substrate including a silicon-containing film and a mask on the silicon-containing film,
controlling a temperature of a substrate support on which the substrate is placed to 0 °C or lower,
supplying a first process gas containing a hydrogen fluoride gas and a halogen-containing gas, and
etching the silicon-containing film with plasma generated from the first process gas.

2. The plasma processing apparatus according to claim 1, wherein the hydrogen fluoride gas has a highest flow rate among components of the first process gas which are not an inert gas.

3. The plasma processing apparatus according to claim 1, wherein
the hydrogen fluoride gas has a flow rate of at least 70 vol% of a total flow rate of components of the first process gas which are not an inert gas.

4. The plasma processing apparatus according to claim 1, wherein
the hydrogen fluoride gas has a flow rate of not less than 70 vol% and not more than 96 vol% of a total flow rate of components of the first process gas which are not an inert gas.

5. The plasma processing apparatus according to claims 1 to 4, wherein the first process gas further contains a carbon-containing gas.

6. The plasma processing apparatus according to claim 5, wherein the carbon-containing gas contains at least one selected from a group consisting of a fluorocarbon gas, a hydrofluorocarbon gas, and a hydrocarbon gas.

7. The plasma processing apparatus according to claims 1 to 6, wherein the first process gas further contains an inert gas.

8. The plasma processing apparatus according to claim 7, wherein the inert gas contains at least one selected from a group consisting of nitrogen gas, Ar gas, Kr gas, and Xe gas.

9. The plasma processing apparatus according to claims 1 to 8, wherein the halogen-containing gas contains at least one selected from a group consisting of a carbon-free fluorine-containing gas, a chlorine-containing gas, a bromine-containing gas, and an iodine-containing gas.

10. The plasma processing apparatus according to claims 1 to 8, wherein the halogen-containing gas contains at least one selected from a group consisting of SF₆, NF₃, XeF₂, SiF₄, IF₇, ClF₅, BrF₅, AsF₅, NF₅, PF₃, PF₅, POF₃, BF₃, HPF₆, WF₆, Cl₂, SiCl₂, SiCl₄, CCl₄, BCl₃, PCl₃, PCl₅, POCl₃, HBr, CBr₂F₂, C₂F₅Br, PBr₃, PBr₅, POBr₃, HI, CF₃I, C₂F₅I, C₃F₇I, IF₅, IF₇, I₂, and PI₃.

11. The plasma processing apparatus according to claims 1 to 10, wherein the first process gas further contains at least one selected from a group consisting of a phosphorus-containing gas, a sulfur-containing gas, and a boron-containing gas

12. The plasma processing apparatus according to claims 1 to 11, wherein the mask is a carbon-containing mask, a boron-containing mask, or a metal-containing mask.

13. The plasma processing apparatus according to claim 12, wherein, the carbon-containing mask is formed from at least one selected from a group consisting of spin-on carbon, tungsten carbide, amorphous carbon, and boron carbide.

14. The plasma processing apparatus according to claims 1 to 11, wherein the mask is formed from at least one selected from a group consisting of titanium nitride, titanium oxide, and tungsten.

15. The plasma processing apparatus according to claims 1 to 11, wherein the mask is formed from silicon boride, boron nitride, or boron carbide.

16. The plasma processing apparatus according to claims 1 to 15, wherein the silicon-containing film is a film stack including one or more silicon oxide films and one or more silicon nitride films.

17. The plasma processing apparatus according to claims 1 to 15, wherein the silicon-containing film is a film stack including one or more silicon oxide films and one or more polysilicon films.

18. A plasma processing apparatus comprising,
a chamber having a gas inlet and a gas outlet;
a plasma generator; and
a controller configured to cause
placing a substrate in the chamber, the substrate including a silicon-containing film and a mask on the silicon-containing film,
supplying a first process gas containing a hydrogen fluoride gas and a halogen-containing gas, and
etching the silicon-containing film with plasma generated from the first process gas.

19. A substrate processing method, comprising:
providing a substrate in a chamber, the substrate including a silicon-containing film and a mask on the silicon-containing film;
supplying a first process gas containing a hydrogen fluoride gas and a halogen-containing gas; and
etching the silicon-containing film with plasma generated from the first process gas.

20. An etching gas composition for etching a silicon-containing film, comprising:
a hydrogen fluoride gas; and
a halogen-containing gas.
